Europäisches Patentamt

European Patent Office

Office européen des brevets

(11) Veröffentlichungsnummer: **0 025 970**
**A1**

(12) **EUROPÄISCHE PATENTANMELDUNG**

(21) Anmeldenummer: **80105551.8**

(22) Anmeldetag: **16.09.80**

(51) Int. Cl.³: **H 03 F 3/45**

(30) Priorität: **24.09.79 DE 2938592**
**24.09.79 DE 2938544**

(43) Veröffentlichungstag der Anmeldung:
**01.04.81 Patentblatt 81/13**

(84) Benannte Vertragsstaaten:
**AT CH DE FR GB IT LI NL SE**

(71) Anmelder: **SIEMENS AKTIENGESELLSCHAFT Berlin und München**
**Postfach 22 02 61**
**D-8000 München 22(DE)**

(72) Erfinder: **Rössler, Bernward, Dipl.-Ing.**
**Franz-Reber-Weg 6**
**D-8000 München 71(DE)**

(54) Operationsverstärker in IG-FET-Technologie.

(57) IG-FET-Operationsverstärker mit Dämpfung der Gleichtaktkomponente der Eingangssignale (P15, P16),
- mit einem Differenzverstärker, der drei Stromzweige mit je einem Verarmungstyp-Drainwiderstand (3, 4, 300) und mindestens einem Anreicherungstyp-Verstärker-FET (1, 2, 200, 100) enthält, wobei die Gates des ersten Verstärker-FET (1) im ersten Stromzweig sowie des dritten Verstärker-FET (2) im dritten Stromzweig mit dem ersten Signaleingang (P15), das Gate des zweiten Verstärker-FET (100) im zweiten Stromzweig mit dem zweiten Signaleingang (P16) und dessen Drain (über P10) mit dem Operationsverstärkerausgang (Aus) verbunden ist, der dritte Verstärker-FET (2) von einem vierten Anreicherungstyp-Verstärker-FET (200), dessen Gate mit dem zweiten Signaleingang (P16) verbunden ist, überbrückt ist, und ein gemeinsamer Anreicherungstyp-Sourcewiderstand (5) als Stromquelle dient,
- mit einer Gleichtakt-Gegenkopplungsschaltung, die eine erste Verstärkerstufe mit einem ersten FET (6/18) und zweiten Anreicherungstyp-FET (7/20) enthält, wobei das Gate des ersten FET (6/18) mit dem Drain des dritten Verstärker-FET (2) und das Gate des zweiten FET (7/20) mit einer Vorspannung (P4/P5), sowie dessen Drain mit dem Gate des Sourcewiderstandes (5) verbunden ist.

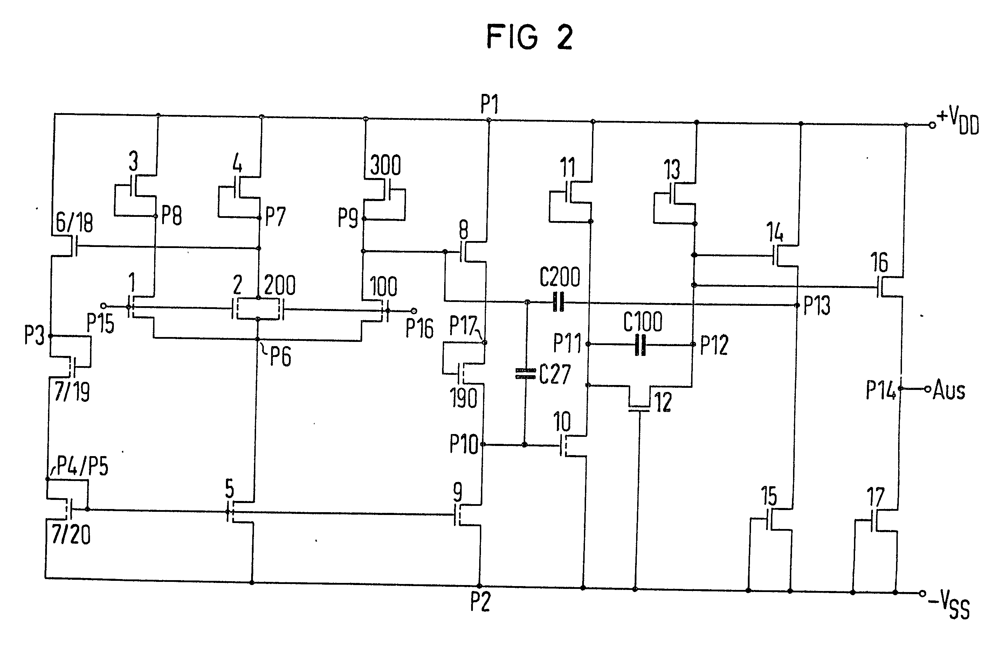

Die erste Verstärkerstufe (6,7) bildet gleichzeitig den Vorspannungserzeuger (18, 20), indem der Drain des zweiten FET (7/20) mit dem Gate dieses zweiten FET (7/20) verbunden ist (Fig. 2), und/oder der erste FET (6/18) ist vom Verarmungstyp. (Fig.2).

FIG 2

SIEMENS AKTIENGESELLSCHAFT  Unser Zeichen
Berlin und München  VPA 79 P 6 1 8 7 EUR

Operationsverstärker in IG-FET-Technologie.

Die Erfindung betrifft eine elektronische Schaltungsanordnung, nämlich einen speziellen integrierten Operationsverstärker in IG-FET-Technologie, der vor allem für einen Filter-Baustein eines digitalen Fernsprech-Vermittlungssystems entwickelt wurde. Nach zuverlässigen Operationsverstärkern mit möglichst geringem Leistungsverbrauch und hohen Herstellungstoleranzen wird z.Zt. weltweit geforscht, denn z.B. für integrierte Kondensator-Schalter-Filter werden gleich oft 15 solche Operationsverstärker benötigt, die jeder für sich daher z.B. auch möglichst platzsparend sein sollen, vgl.z.B. Colloque international de communication, Paris 7. bis 11. Mai 1979, S. 921 bis 925, insbesondere Fig. 7, sowie z.B. den Filter-Chip 2912 der Firma INTEL. Der erfindungsgemäße Operationsverstärker ist aber auch in sonstigen Fällen zur Weitergabe von empfangenen Differenz-Eingangssignalen über den unsymmetrischen Operationsverstärker-Ausgang an geringe ohmsche Leistungen verbrauchende, z.B. vor allem an integrierte kapazitive Belastungen darstellende, Verbraucher geeignet.

Be 1.Ky /17.9.1979  BAD ORIGINAL

Die Erfindung geht nämlich aus von einem Operationsverstärker in IG-FET-Technologie mit Dämpfung der Gleichtaktkomponente der Eingangssignale, die dem Differenz-Eingangssignal überlagert ist, mit unsymmetrischem Ausgang zur Weitergabe des empfangenen Differenz-Eingangssignals, mit einem Differenzverstärker und mit einer Gleichtakt-Gegenkopplungsschaltung, jeweils mit bevorzugt gesättigten IG-FETs, wobei der Differenzverstärker

- zwischen den Anschlüssen der Gleichstromversorgung eingefügt ist,
- drei Stromzweige mit je einem eigenen Verarmungstyp-Drainwiderstand und mit je einem Anreicherungstyp-Verstärker-FET enthält, bei denen
-- der erste Verstärker-FET im ersten Stromzweig sowie der dritte Verstärker-FET im dritten Stromzweig gemeinsam an ihren Gates mit dem ersten Signaleingang und
-- der zweite Verstärker-FET im zweiten Stromzweig an seinem Gate mit dem zweiten Signaleingang und an seinem Drain, evtl.über einen Zusatzverstärker, mit dem Operationsverstärkerausgang verbunden ist,
-- der dritte Verstärker-FET an seiner Source-Drain-Strecke von der Source-Drain-Strecke eines vierten Anreicherungstyp-Verstärker-FET, dessen Gate mit dem zweiten Signaleingang verbunden ist, überbrückt ist,
-- die im Ruhezustand*) von gleich großen Strömen durchflossenen Drainwiderstände zumindest im zweiten und im dritten Stromzweig Kanalbreite/Kanallänge-Verhältnisse W/L = S aufweisen, die untereinander alle gleich groß sind, nämlich den Wert Sd aufweisen, und
-- der erste und der zweite Verstärker-FET Kanalbreite/Kanallänge-Verhältnisse S aufweisen, die untereinander gleich groß sind, nämlich jeweils den Wert Sv aufweisen, und          *) ,d.h. ohne Eingangssignal,

der dritte und der vierte Verstärker-FET Kanalbreite/
Kanallänge-Verhältnisse S aufweisen, die untereinander
zwar gleich groß sind, aber im Vergleich zum ersten und
zum zweiten Verstärker-FET jeweils halb so groß sind,
nämlich jeweils den Wert 0,5 Sv aufweisen,
- einen für alle drei Stromzweige gemeinsamen Anreicherungstyp-Sourcewiderstand als Stromquelle, deren Strom
sich auf die drei Stromzweige verteilt, enthält, und
wobei die Gleichtakt-Gegenkopplungsschaltung
- zwischen Anschlüssen der gleichen Gleichstromversorgung, hinsichtlich der Gleichstromversorgung parallel
zum Differenzverstärker, eingefügt ist,
- eine erste Verstärkerstufe, mit einem ersten gesteuerten Hilfs-FET und in Reihe dazu einem zweiten gesteuerten Anreicherungstyp-Hilfs-FET, enthält, bei
dem
-- der erste Hilfs-FET an seinem Gate mit den Drains des
dritten und des vierten Verstärker-FET verbunden ist
und
-- der zweite Hilfs-FET an seinem Gate mit einer mittels
eines Hilfsspannungsteilers aus der gleichen Gleichstromversorgung erzeugten Vorspannung, sowie an seinem Drain mit dem Gate des Sourcewiderstandes des
Differenzverstärkers verbunden ist.

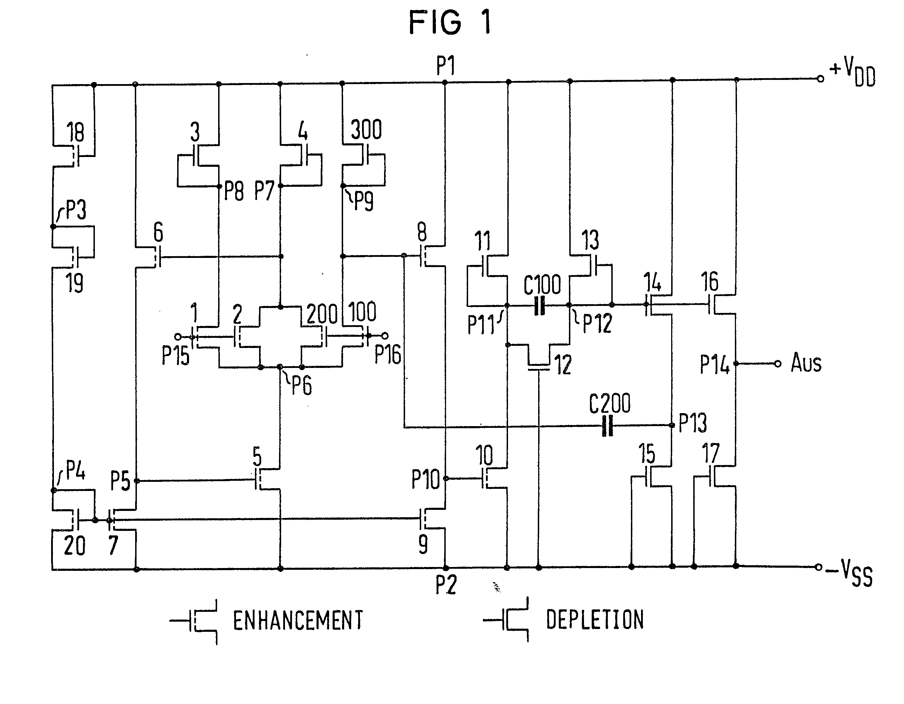

Ein solcher, einschließlich Zusatzverstärker bereits
nur 3 mW verbrauchender Operationsverstärker ist durch
IEEE ISSCC 1979, Digest of Techn.P., S. 188/189, insbesondere Figur 1 bekannt - diese Figur entspricht im
wesentlichen der Figur 1 der hier vorliegenden Schrift,
wobei hier jedoch teilweise geänderte Hinweiszeichen
und geänderte Symbole für Verarmungstyp-FETs und für
Anreicherungstyp-FETs verwendet werden. Dabei stellt
dieser bekannte Operationsverstärker de facto eine Weiterenwicklung eines anderen, noch 10 mW verbrauchenden

Operationsverstärkers dar, vgl. IEEE J. of Sol.St.Circ.,
SC-13, 760 bis 766, insbesondere Fig. 5 und 10.

Die hier vorliegende Fig. 1 zeigt nämlich *einen* Operationsverstärker in IG-FET-Technologie, bei dem die Gleichtaktkomponenten der Eingangssignale, die dem Differenz-Eingangssignal überlagert sind, durch Gegenkopplung weitgehend gedämpft sind. Ein unsymmetrischer Ausgang Aus dient zur Weitergabe des an den Schaltungspunkten P15/P16 empfangenen, verstärkten Differenz-Eingangssignals, wozu ein Differenzverstärker mit den Verstärker-FETs 1, 2, 200, 100 und eine nur für die Gleichtaktkomponenten wirksame Gegenkopplungsschaltung mit den Hilfs-FETs 6, 7 angebracht ist, jeweils mit bevorzugt gesättigten IG-FETs, teils vom Verarmungstyp, teils vom Anreicherungstyp.

Dabei ist der Differenzverstärker zwischen den Anschlüssen +VDD/-VSS der Gleichstromversorgung eingefügt, wobei er drei, statt wie meistens üblich zwei, Stromzweige mit je einem eigenen Verarmungstyp-Drainwiderstand 3, 4, 300 und mit je einem Anreicherungstyp-Verstärker FET 1, 2, 100 enthält. Dadurch ist der Verstärkungsfaktor des Differenzverstärkers größer als wenn Anreicherungstyp-Drainwiderstände verwendet würden, vgl. IEEE J. of Sol.St.Circ., SC-13, No. 6, Dez. 1978, S. 760-766, insbesondere S. 761, Abschnitt V.

Der erste Verstärker-FET 1 im ersten Stromzweig 1/3 sowie der dritte Verstärker-FET 2 im dritten Stromzweig 2/4 sind gemeinsam an ihren Gates mit dem ersten Signaleingang P15 und der zweite Verstärker-FET 100 im zweiten Stromzweig 100/300 ist an seinem Gate mit dem zweiten Signaleingang P16 verbunden.

BAD ORIGINAL

Der dritte Verstärker-FET ist an seiner Source-Drain-Strecke P6/P7 von der Source-Drain-Strecke des vierten Anreicherungstyp-Verstärker-FET 200, dessen Gate mit dem zweiten Signaleingang P16 verbunden ist, überbrückt.

Zumindest die Drainwiderstände 4, 300 im zweiten und im dritten Stromzweig weisen Kanalbreite/Kanallänge-Verhältnisse W/L = S auf, die untereinander alle gleich groß sind, die nämlich jeweils den gleichen Wert Sd aufweisen. Der erste und der zweite Verstärker-FET 1, 100 weisen Kanalbreite/Kanallänge-Verhältnisse S auf, die ebenfalls untereinander gleich groß sind, die nämlich jeweils den Wert Sv aufweisen, der gleich oder verschieden vom Wert Sd sein kann. Der dritte und der vierte Verstärker-FET 2, 200 weisen Kanalbreite/Kanallänge-Verhältnisse S auf, die untereinander zwar gleich groß sind, die aber im Vergleich zum ersten und zum zweiten Verstärker-FET 1, 100 jeweils halb so groß sind, nämlich jeweils den Wert 0,5 Sv aufweisen.

Der Differenzverstärker enthält ferner einen für alle drei Stromzweige gemeinsamen Anreicherungstyp-Sourcewiderstand 5 als Stromquelle, deren Strom sich auf die drei Stromzweige 1/3, 2/200/4, 100/300 verteilt.

Wenn an den Signaleingängen P15, P16* weder ein Gleichtakt-, noch ein Differenz-Eingangssignal liegt, liegt an den Schaltungspunkten P7, P8, P9 jeweils gleiches Potential, da die Ströme durch die Verstärker-FETs 1, 100 zwar unter sich gleich groß, aber wegen der Verhältnisse S jeweils doppelt so groß wie die Ströme durch die Verstärker-FETs 2 und 200 sind.   *)ein Ruhepotential, also

Falls an den Signaleingängen P15/P16 ein reines Gleichtakt-Eingangssignal liegt, wären die Ströme durch die Verstärker-FETs weiterhin nahezu unverändert, falls sich das Potential am Schaltungspunkt P5 der Gleichtaktgegenkopplungsschaltung 6,7 nicht ändern würde - diese Gegenkopplungsschaltung 6, 7 dient jedoch dazu, in diesem Falle das Potential an den Schaltungspunkten P7, P8, P9 durch eine entsprechende Regelung des Potentials am Schaltungspunkt P5*)zu stabilisieren, also die Gleichtaktkomponente des Eingangssignals zu unterdrücken.

*) also des Stromes durch 5,

Falls hingegen an den Signaleingängen P15/P16 ein reines Differenz-Eingangssignal nicht zu hoher Amplitude liegt, wäre der Strom durch den Drainwiderstand 4 unverändert, aber der Strom durch den Drainwiderstand 3 um jenen Wert vermindert (vergrößert),um den der Strom im Drainwiderstand 300 vergrößert (vermindert) ist. Die Gleichtakt-Gegenkopplungsschaltung 6, 7 wird daher vom in diesem Falle unveränderten Potential des Schaltungspunktes P7 gesteuert, wobei die Verstärker-FETs 2, 200 zusammen mit ihrem Drainwiderstand 4 sozusagen auch als Gleichtakt-Komponenten-Meßanordnung in dem Rumpf-Differenzverstärker 5, 1, 3, 100, 300 wirkt.

Die Gleichtakt-Gegenkopplungsschaltung 6, 7 ist zwischen Anschlüssen +VDD/-VSS bzw. P1/P2 der gleichen Gleichstromversorgung, hinsichtlich der Gleichstromversorgung parallel zum Differenzverstärker, eingefügt und enthält eine erste Verstärkerstufe 6,7 mit einem ersten gesteuerten Verarmungstyp-Hilfs-FET 6 und in Reihe dazu einen zweiten gesteuerten Anreicherungstyp-Hilfs-FET 7. Der erste Hilfs-FET 6 ist an seinem Gate mit den Drains des dritten und des vierten Verstärker-FET 2, 200 verbunden.

Der erste Hilfs-FET 8 einer nachgeschalteten zweiten Verstärkerstufe 8/9 ist in diesem bekannten Operationsverstärker an seinem Gate mit dem Drain des zweiten Verstärkers-FET 100 und an seiner Source am Schaltungspunkt P10, hier über einen nachgeschalteten Zusatzverstärker 10 bis 17, mit dem Operationsverstärkerausgang Aus bzw. P14 verbunden.

Der zweite Hilfs-FET 7 der ersten Verstärkerstufe 6/7 ist an seinem Gate sowohl mit dem Gate des zweiten Hilfs-FET 9 der zweiten Verstärkerstufe 8/9 als auch mit einer Vorspannung verbunden, die mittels eines nur aus Anreicherungstyp-FETs gebildeten Hilfsspannungsteilers 18/19/20 aus der gleichen Gleichstromversorgung +VDD/-VSS am Schaltungspunkt P4 erzeugt wird. Der zweite Hilfs-FET 7 ist außerdem an seinem Drain bzw. am Schaltungspunkt P5 mit dem Gate des Sourcewiderstandes 5 des Differenzverstärkers verbunden.

Die das Gate des ersten Hilfs-FET 6 steuernde Gleichtaktkomponente des Eingangssignals bewirkt also Potentialschwankungen am Schaltungspunkt P5 gleicher Phase wie am Schaltungspunkt P7, und damit auch am Gate des Sourcewiderstandes 5 - die erste Verstärkerstufe 6, 7 stellt nämlich einen Sourcefolger dar, wobei der Hilfs-FET 7 hierfür den Sourcewiderstand des gesteuerten Hilfs-FET 6 bildet.

Diese erste Verstärkerstufe 6, 7 bewirkt eine Gegenkopplung, indem das Potential am Schaltungspunkt P5 den Sourcewiderstand 5 des Differenzverstärkers so steuert, daß die am Schaltungspunkt P7 und damit auch an dem Schaltungspunkt P9, P10, P14 auftretende Gleichtaktkomponente nahezu vollkommen wieder verschwindet. Die zweite Verstärkerstufe 8, 9 wird also bei diesem bekannten Operationsverstärker an sich nicht zur Kompensation oder Gegenkopplung des Gleichtakt-Eingangssignals mit ausgenutzt, weswegen diese zweite Verstärkerstufe 8, 9 hier als ein zwischen dem Differenzverstärker 1, 2, 200, 100 und dem Zusatzverstärker 10 bis 17 eingefügter Zwischenverstärker mit Sourcefolger-Eigenschaft zur Weiterleitung des bereits kompensierten Eingangssignales aufgefaßt werden kann.

Beim bekannten Operationsverstärker dient der Hilfsspannungsteiler 18/19/20 vor allem zur Erzeugung der Vorspannung für die Gates der zweiten Hilfs-FETs 7,9, wodurch letztere zuverlässig im gesättigten Zustand betrieben werden. Indem sogar möglichst alle IG-FETs im gesättigten Zustand betrieben werden, wird nämlich die relative hohe Verstärkung bei bereits relativ großen Herstellungstoleranzen erreicht.

Bei diesem Operationsverstärker ist nämlich die Toleranz für die Herstellung, bzw. für die Dimensionierung und Dotierung, jedes FET bereits beachtlich groß. Solche Herstellungsungenauigkeiten, z.B. Streuungen der Verhältnisse S würden nämlich, falls die Gegenkopplungsschaltung 6, 7 fehlen würde, starke Verschiebungen der Arbeitspunkte bewirken und damit den hohen Anforderungen an die Zuverlässigkeit solcher Operationsverstärker nicht entsprechen. Solche Herstellungsungenauigkeiten wirken sich nämlich aus, als ob dem Differenz-Eingangssignal ein in Wahrheit nicht vorhandenes Gleichtakt-Eingangssignal überlagert wäre, was sich auch auf das Ausgangssignal am Ausgang Aus auswirken würde. Die Gleichtakt-Gegenkopplungsschaltung vermindert also nicht nur wirklich vorhandene Gleichtakt-Eingangssignale, sondern auch die durch die Herstellungsungenauigkeiten vorgetäuschten Gleichtakt-Eingangssignale, was die Ausschußquote von Chips, die z.B. 15 solche Operationsverstärker enthalten, deutlich vermindert.

Der bekannte Operationsverstärker hat also, ebenso wie die Erfindung, insbesondere den Vorteil,

- die zulässigen Herstellungstoleranzen stark zu vergrößern,
- die wirklichen und die vorgetäuschten Gleichtaktkomponenten weitgehend zu unterdrücken,
- einen geringen Leistungsverbrauch aufzuweisen und
- eine geringe Chipfläche zu benötigen.

Bei dem obengenannten anderen, vergleichsweise sehr aufwendigen 10 mW-Operationsverstärker ist bereits bekannt, vgl. IEEE J. of Sol.St. Circ., SC-13, S. 760-766, Fig. 5 und 10, einen Hilfsspannungsteiler, mit ungesteuertem Verarmungstyp-FET und in Reihe angebrachtem, am Drain mit dem Gate verbundenen Anreicherungstyp-FET, zur Erzeugung einer Vorspannung am Gate des Sourcewiderstandes des dortigen Differenzverstärkertypes anzubringen.

Die Erfindung hat die Aufgabe
- die bisher noch immer viel zu hohe Ausschußquote bei der Herstellung des Operationsverstärkers durch eine geschickte Dimensionierung dieses Operationsverstärkers weiter zu verringern, damit die Realisierung in einem großintegrierten IG-FET-Baustein ernstlich in Betracht kommt, vor allem falls sogar mehrere solche Operationsverstärker gleichzeitig auf demselben IG-FET-Baustein, z.B. auf einem Kondensator-Filter-Baustein, angebracht werden sollen.

Die Erfindung geht also von dem eingangs sowie im Oberbegriff des Patentanspruchs 1 genannten Operationsverstärker aus. Zur Lösung der Aufgabe der Erfindung sind grundsätzlich zwei verschiedene Wege möglich, die jeweils für sich verschiedene zusätzliche Vorteile haben. Beide Wege werden aber bevorzugt gleichzeitig am selben Operationsverstärker angewendet, wodurch dann der Operationsverstärker auch die Kombination der verschiedenen zusätzlichen Vorteile beider Wege aufweist.

Der erste Weg hat den zusätzlichen Vorteil,
- die Herstellungstoleranzen für die Kanalbereichsdotierungsintensitäten der Verarmungstyp-FETs mit geringem Aufwand weiter zu vergrößern, ohne die genannten übrigen Vorteile des Operationsverstärkers zu beeinträchtigen.

Dieser erste Weg, der im Patentanspruch 1 angegeben ist,
besteht darin, daß
- der erste Hilfs-FET der der ersten Verstärkerstufe ein
Verarmungstyp-FET ist.

Der zweite Weg hat den zusätzlichen Vorteil,
- den Leistungsverbrauch weiter zu vermindern,
- die benötigte Chipfläche weiter zu vermindern,
- die Übertragung parasitärer Wechselsignale (Sprachsignale) auf der Gleichstromversorgung zum Verstärkerausgang weiter zu dämpfen (power supply rejection
ratio' = PSRR erhöhen).

Dieser zweite Weg, der im Patentanspruch 2 angegeben ist,
besteht darin, daß
- die erste Verstärkerstufe gleichzeitig den Hilfsspannungsteiler bildet, indem der Drain des zweiten Hilfs-
FET dieser Verstärkerstufe mit dem Gate dieses zweiten Hilfs-FET verbunden ist.

Die in den Unteransprüchen genannten Weiterbildungen gestatten zusätzlich Verbesserungen, nämlich die Maßnahme
von Patentanspruch
- 3, insbesondere die erste Stufe eines nachgeschalteten
Zusatzverstärkers zusätzlich zur Kompensation der
restlichen, durch Gegenkopplung noch nicht völlig unterdrückten wirklichen und der vorgetäuschten Gleichtaktkomponenten mit auszunutzen, und die Übertragung

Die Erfindung und Weiterbildungen werden anhand der in den Figuren gezeigten Ausführungsbeispiele weiter erläutert, wobei die Figur

- 1, wie angegeben, den bekannten Operationsverstärker,
- 2, ein Ausführungsbeispiel der Erfindung und
- 3, ein insbesondere besonders geringe Chipflächen und besonders geringe Gleichstromversorgungsleistungen benötigendes Ausführungsbeispiel der Erfindung zeigen.

Beim ersten Weg ist also vorgesehen, vgl. weiterhin zunächst Figur 1, den ersten Hilfs-FET 6 der ersten Verstärkerstufe 6, 7 als Verarmungstyp-FET wie die Drainwiderstände 3, 4, 300, statt als Anreicherungstyp auszubilden. Dieser erste Hilfs-FET kann also ohne großem Aufwand in dem gleichen Prozeßschritt wie diese Drainwiderstände auf dem Chip hergestellt werden.

Der erste Hilfs-FET 6 vom Verarmungstyp wird bevorzugt so dimenioniert bzw. betrieben, daß am Schaltungspunkt P5, sogar weitgehend unabhängig von Dotierungsintensitäts-Toleranzen, das Ruhepotential ähnlich groß wie an den Schaltungspunkten P7, P8, P9 ist, also an den an Source und Gate überbrückten Drainwiderständen. Dabei wird das Wechselsignal des Schaltungspunktes P7 insbesondere unabhängiger von Dotierungstoleranzen der Verarmungstyp-FETs über den Sourcewiderstand 5 im beabsichtigtem Maße gegengekoppelt als wenn der erste Hilfs-FET 6 vom Anreicherungstyp ist - bei der Erfindung wird mit geringem Aufwand und mit weniger Anforderungen an Herstellungstoleranzen, also zuverlässiger rückgekoppelt als beim bekannten Operationsverstärker, wodurch auch die bei Massenfertigung bekanntlich meistens sehr hohe Ausschußquote bei der Chipherstellung gesenkt wird.

0025970

von im Frequenzband des Eingangssignals (z.B. Sprachfrequenzband) liegenden parasitären Wechselspannungen,
die der Gleichstromversorgung überlagert sind, von der
Gleichstromversorgung zum Operationsverstärkerausgang
noch stärker zu dämpfen, also das PSRR weiter zu erhöhen;

- 4, insbesondere die Gleichtakt-Kompensation durch eine
relativ einfache Dimensionierung der Kanalbereiche
weiter zu verbessern und das PSRR weiter zu erhöhen;

- 5, insbesondere den Pegel der vom Differenzverstärker
abgegebenen Ausgangssignale auf angenehme niedrigere
Werte zu verschieben, und den Frequenzbereich, in dem
die Gleichtakt-Kompensation und die PSRR-Dämpfung
stattfindet, zu vergrößern;

- 6, insbesondere den Chipflächenbedarf sowie die Einschwingzeit des zwischen Eingang und Ausgang durch eine
Kapazität überbrückten, als Integrator verwendeten
Operationsverstärkers weiter zu verringern und

- 7, insbesondere die Rauscheigenschaften zu verbessern,
indem nämlich damit das Rauschen der Verstärker-FETs
vermindert wird.

Durch die erfindungsgemäß gestaltete Gegenkopplung erreicht man daher im Vergleich zur bekannten Rückkopplung, daß die wirklichen und die vorgetäuschten Gleichtaktkomponenten nun noch zuverlässiger gedämpft werden, wobei auch die Herstellungstoleranzen noch größer sein dürfen.

Beim zweiten Weg ist also vorgesehen, den Hilfsspannungsteiler 18/19/20 wegzulassen, indem die erste Verstärkerstufe durch Einfügen einer leitenden Verbindung zwischen Drain und Gate des zweiten Hilfs-FET 7 die Funktion des Hilfsspannungsteilers mit übernimmt, wobei diese Verbindung ohne großen Aufwand in dem gleichen Prozeßschritt wie die Herstellung sonstiger leitender Verbindungen auf dem Chip hergestellt werden kann.

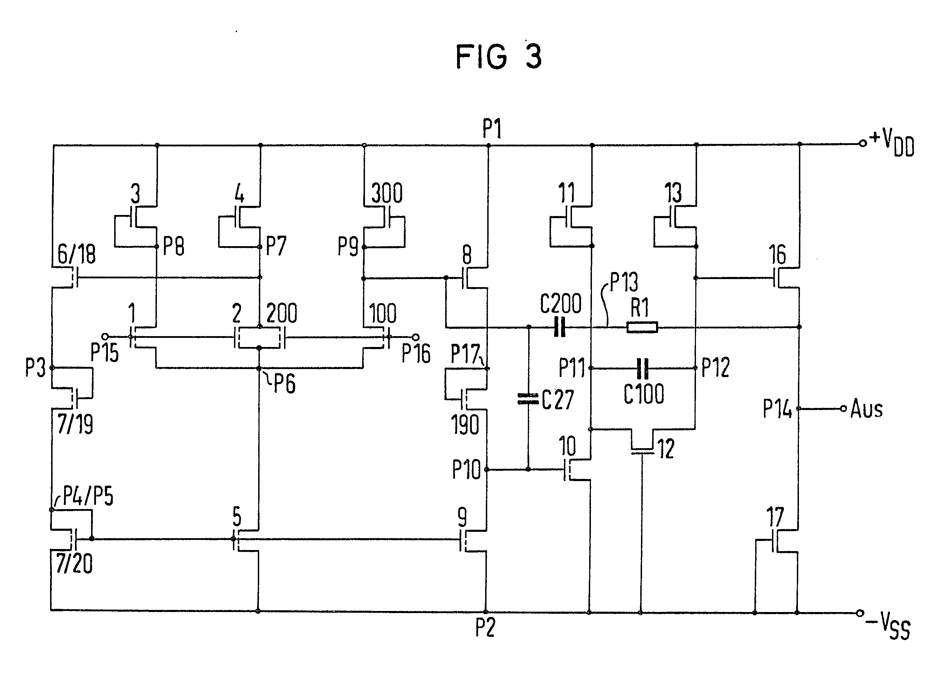

Die Figuren 2 und 3 zeigen Beispiele der Erfindung, bei der der in Figur 1 gezeigte Hilfsspannungsteiler 18/19/20 weggelassen wurde, indem der Hilfs-FET 6 die Funktion des FET 18, teilweise auch des FET 19, und der Hilfs-FET 7 die Funktion des FET 20, teilweise auch des FET 19, mit übernimmt. Das senkt den Leistungsverbrauch und den Chipflächenbedarf im Vergleich zum bekannten Operationsverstärker. Weil die Erfindung weniger FETs als der bekannte Operationsverstärker benötigt, sind weniger Bestandteile mit beachtenswerten Herstellungstoleranzen vorhanden, wodurch bei der Erfindung die Ausschußquote vermindert ist. Hierzu ist also der Drain P5 des zweiten Hilfs-FET 7 mit dessen Gate P4, vgl. Figur 1, verbunden, was technologisch keine Schwierigkeiten bereitet. Durch diese Maßnahme wird das Ruhepotential des Gate des zweiten Hilfs-FET 7 von der Verstärkerstufe 6, 7 selbst erzeugt. Bei der Erfindung wird also die erste Verstärkerstufe 6, 7 nicht nur zur Gegenkopplung der Gleichtaktkomponente wie beim bekannten Operationsverstärker ausgenutzt, sondern auch zur Vorspannungserzeugung am Gate
des zweiten Hilfs-FET 7 um diesen zuverlässig in seinen
gesättigten Zustand zu steuern.

Bei der Erfindung, vgl. Fig. 2, wird zwar das Gate dieses Hilfs-FET 7 zusätzlich von der Gleichtaktkomponente
des Schaltungspunktes P7 gesteuert, wodurch der Verstärkungsfaktor dieser Verstärkerstufe 6, 7 und damit
die Gegenkopplung im Vergleich zum bekannten Operationsverstärker etwas vermindert wird, - was aber im allgemeinen zulässig ist, und zwar jedenfalls dann, vgl.
Fig. 2, wenn eine weitere Maßnahme zur Erhöhung der
Gleichtaktkomponenten-Dämpfung getroffen wird, wenn
nämlich z.B. die zweite Verstärkerstufe 8, 9 mit deren
erstem Hilfs-FET 8 und mit deren zweitem Hilfs-FET 9
vom Anreicherungstyp eingefügt ist, sowie das Gate vom
ersten Hilfs-FET 8 mit dem Schaltungspunkt P9 und das
Gate des zweiten Hilfs-FET 9 mit P4/P5 verbunden ist,
und der Schaltungspunkt P10 den Signalausgang dieses
kompensierten Differenzverstärkers bildet. In diesem
Falle wird auch der zweite Hilfs-FET 9 von der Gleichtaktkomponente des Schaltungspunktes P7 über den Schaltungspunkt P4 = P5 gesteuert. Hier ist nämlich möglich,
im Gegensatz zum bekannten Operationsverstärker von
Figur 1, diese zweite einen Sourcefolger darstellende
Verstärkerstufe 8, 9 gleichzeitig als ein sehr wirksames
PSRR-Dämpfungsglied und als eine Gleichtakt-Kompensationsschaltung zu verwenden, insbesondere weil die
Gleichtaktkomponente am Gate des zweiten Hilfs-FET 9,
und damit am Schaltungspunkt P10, jenen Rest der Gleichtaktkomponente, der über den Schaltungspunkt P9 auf den
Hilfs-FET 8 wirkt, bei hohem zulässigen Herstellungstoleranzen weiter kompensieren kann, wie nun noch genauer erläutert wird.

Dieses überraschende Ergebnis, - das letzten Endes bereits beim bekannten Operationsverstärker erreichbar wäre, würde man dort den Drain und das Gate des zweiten Hilfs-FET 7 miteinander verbinden - wird anschaulich leichter verständlich, wenn man sich zunächst vorstellt, beide Potentiale der Eingänge P15, P16 würden rein gleichphasig schwanken. Dann werden zwar weiterhin nahezu unverändert große Ströme durch die Drainwiderstände 3, 4, 300 fließen - und zwar in jedem dieser Drainwiderstände mit jeweils gleicher Stromstärke, z.B. in jedem 3,9 $\mu$A - aber die Potentiale an den Schaltungspunkten P8, P7, P9 werden alle, bez. P15/P16 gegenphasig, mitschwanken. Diese gegenphasige Gleichtaktkomponente wird zunächst durch die Gegenkopplung über den, bez. P15/P16 ebenfalls gegenphasig, schwankenden Schaltungspunkt P5 = P4 stark gedämpft, z.B. um 48 dB. Die bez. P15/P16 gegenphasige Schwankung an P9 und P5 = P4 steuert hier nämlich die zweite Verstärkerstufe 8,9 zweifach, erstens über den Schaltungspunkt P9 das Gate des ersten Hilfs-FET 8 und zweitens über den Schaltungspunkt P4 = P5 auch das Gate des zweiten Hilfs-FET 9. Diese zweifache Steuerung bewirkt, daß die über den ersten Hilfs-FET 8 an dem Schaltungspunkt P10 erzeugte Gleichtaktkomponenten-Potentialschwankung mehr oder weniger durch die über den zweiten Hilfs-FET 9 an dem Schaltungspunkt P10 erzeugte Gleichtaktkomponenten-Potentialschwankung kompensiert werden kann.

Man kann zusätzlich die ersten Hilfs-FETs 6, 8 der beiden Verstärkerstufen 6/7, 8/9 jeweils als Verarmungstyp-FETs, wie die Drainwiderstände 3, 4, 300, statt als Anreicherungstyp ausbilden. Diese ersten Hilfs-FETs 6,8 können also ohne großen Aufwand in dem gleichen Prozeßschritt wie diese Drainwiderstände auf dem Chip hergestellt werden.

Der erste Hilfs-FET 6 vom Verarmungstyp wird bevorzugt
so dimensioniert bzw. betrieben, daß am Schaltungspunkt
P3, sogar weitgehend unabhängig von Dotierungsintensitäts-Toleranzen, das Ruhepotential ähnlich groß wie an
den Schaltungspunkten P7, P8, P9 ist, also an den an
Source und Gate überbrückten Drainwiderständen. Dabei
wird das Wechselsignal des Schaltungspunktes P7 insbesondere unabhängiger von Dotierungstoleranzen der Verarmungstyp-FETs über den Sourcewiderstand 5 im beabsichtigtem Maße gegengekoppelt, als wenn der erste Hilfs-FET
6 vom Anreicherungstyp ist - bei dieser Weiterbildung
wird mit geringem Aufwand und mit weniger Anforderungen
an Herstellungstoleranzen, also zuverlässiger rückgekoppelt als beim bekannten Operationsverstärker, wodurch
auch die bei Massenfertigung bekanntlich meistens sehr
hohe Ausschußquote bei der Chipherstellung gesenkt wird.

Exakte Untersuchungen zeigten, daß, falls beide Verstärkerstufen 6/7, 8/9 hinsichtlich der Verhältnisse S
ihrer FETs untereinander zusätzlich gleich dimensioniert,
also in elektrischer Hinsicht symmetrisch aufgebaut, sind,
die Gleichtaktkomponente am Schaltungspunkt P10 dann -
trotz hoher zulässiger Herstellungstoleranzen und trotz
verminderten Leistungsverbrauchs und trotz verminderter
Chipfläche und verminderter Ausschußquote dieses Beispiels im Vergleich zum bekannten Operationsverstärker -,
besonders leicht bis auf 60 dB unterdrückt werden kann.
Dadurch enthält dann das Potential am Schaltungspunkt
P10 im wesentlichen nur noch die Differenzkomponenten
der Eingangssignale der Schaltungspunkte P15, P16.

Die zweite Verstärkerstufe 8, 9 gestattet also eine weitere verbesserte Unterdrückung der wirklichen und der durch Herstellungstoleranzen nur vorgetäuschten Gleichtaktkomponenten der Eingangssignale.

Beim bekannten Operationsverstärker findet keine solche
Kompensation der restlichen Gleichtaktkomponenten durch
gegenseitig sich löschende Überlagerung am Schaltungspunkt P10 statt. Die durch die Gegenkopplung 6, 7, vgl.
Figur 1, gedämpfte restliche Gleichtaktkomponente am
Schaltungspunkt P9 wird zwar auch dort auf den ersten
Hilfs-FET 8 der zweiten Verstärkerstufe 8, 9 übertragen.
Gleichzeitig wird dort aber die entsprechende andere
Übertragung zum zweiten Hilfs-FET 9 nicht durchgeführt.
Im Gegensatz zum in Figur 2 gezeigten Beispiel der Erfindung wird beim bekannten Operationsverstärker diese
restliche Gleichtaktkomponente über den Schaltungspunkt
P10 zum Ausgang P14/Aus übertragen und dort an Verbraucher weitergegeben.

Überraschenderweise bewirkt die in Fig. 2 gezeigte Kompensationsschaltung aber zusätzlich auch noch eine besonders hohe PSRR-Dämpfung, also eine besonders hohe
Dämpfung der parasitären Wechselspannungen (Sprachfrequenzen), die aufgrund oft unvermeidlicher Kopplungen
der Gleichspannung +VDD/-VSS der Gleichstromversorgung
überlagert sind, so daß am Verstärkerausgang Aus, bzw.
am Schaltungspunkt P10, nur noch die um den Betrag der
PSRR-Dämpfung gedämpften parasitären Wechselsignale
auftreten. Das wird im folgenden näher erläutert:

Parasitäre Wechselspannungen auf der Gleichstromversorgung P1/P2 wirken beim bekannten Operationsverstärker teilweise ähnlich wie Gleichtaktkomponenten der
Eingangssignale an P15, P16 - sie bewirken nämlich
über die Drainwiderstände 3, 4, 300 Wechselspannungen
u.a. an den Schaltungspunkten P8, P7, P9, die aber mit
Hilfe der Gegenkopplung 6, 7 bis auf einen niedrigen restlichen Anteil gedämpft werden, insoweit also, wenn auch gedämpft, weiter über den P9 und über den ersten Hilfs-FET 8 und über P10 an den Ausgang Aus übertragen werden. Gleichzeitig beeinflussen aber die parasitären Wechselspannungen an P1/P2 auch ganz erheblich die Vorspannung am Schaltungspunkt P4 des nur aus Anreicherungstyp-FET bestehenden Hilfsspannungsteilers 18, 19, 20, wodurch zusätzlich erstens recht hohe störende eigene Anteile der parasitären Wechselspannungen dem zweiten Hilfs-FET 9 zugeleitet werden, also auch stark das Potential am Schaltungspunkt P10 beeinflussen, sowie zweitens über den zweiten Hilfs-FET 7, Punkt P5 und Sourcewiderstand 5, wegen der Gegenkopplung 6/7 stark gedämpft, nochmals über P9 und ersten Hilfs-FET 8 den Punkt P10 beeinflussen. Der Einfluß der parasitären Wechselspannungen an P1/P2 auf das Potential von P10 ist dabei auf dem Wege P4 - zweiter Hilfs-FET 9 - P10 besonders stark - so stark, daß über P9 - erster Hilfs-FET 8 de facto keine Kompensation erreicht wird.

Bei dem in Figur 2 gezeigten Beispiel der Erfindung wirken die parasitären Wechselspannungen ebenfalls zunächst über die Drainwiderstände 3, 4, 300 auf die Potentiale der Schaltungspunkte P8, P7, P9, wie die Gleichtaktkomponenten der Eingangssignale an P15/ P16, wobei die entsprechenden Wechselsignale an P8, P7, P9 wegen der Gegenkopplung 6, 7, selbst wenn die ersten Hilfs-FETs 6, 8 vom Anreicherungstyp wären, bis auf einen niedrigen restlichen Anteil gedämpft sind. Dieser gedämpfte restliche Anteil an P9 wird über den ersten Hilfs-FET 8 an P10 übertragen. Dieser restliche Anteil, nun an P7, wird aber auch über den ersten Hilfs-FET 6/18, (vgl. Fig. 2) - P4 = P5 - zweiter Hilfs-FET 9 zu P10 übertragen, also in der gleichen, bei P10 kompensierenden Weise wie bei wirklichen Gleichtaktkomponenten an P15/ P16. Weil bei diesem Beispiel kein eigener, nur aus Anreicherungstyp-FETs gebildeter, in Fig. 1 gezeigter
Hilfsspannungsteiler 18, 19, 20 vorhanden ist, der hohe
störende eigene Anteile an den zweiten Hilfs-FET 9 weiterleiten würde, ist bei dieser Weiterbildung der Erfindung, trotz besonders geringem Leistungsverbrauch und
besonders geringer Chipfläche, eine sehr hohe PSRR-
Dämpfung von z.B. 70 dB erreichbar, insbesondere besonders leicht dann, wenn man auch hierzu, wie schon bez.
der Gleichtaktkomponentenkompensation erwähnt, die erste
Verstärkerstufe 6/18, 7/20 in elektrischer Hinsicht
symmetrisch zur zweiten Verstärkerstufe 8/9 aufbaut, also z.B. mit S6 = S8, S7/19 = S190, S7/20 = S9, und als
erste Hilfs-FETs 6,8, insbesondere zur Vergrößerung der
zulässigen Herstellungstoleranzen und zur Verminderung
der Ausschußquote, jeweils Verarmungstyp-FETs wählt. Bei
diesen Weiterbildungen der Erfindung wirkt also die
zweite Verstärkerstufe 8, 9 nicht nur zusätzlich als
Gleichtakt-Kompensationsschaltung, sondern zusätzlich
noch als sehr wirksames PSRR-Dämpfungsglied.

Die in den Figuren gezeigten Anreicherungstyp-FETs 19,
190 zwischen den ersten und zweiten Hilfs-FETs 6/7, 8/9
wirken, ähnlich wie der FET 19 im Hilfsspannungsteiler
18, 19, 20 von Figur 1, als zusätzlicher Pegelumsetzer,
wodurch die zweiten Hilfs-FETs 7, 9 in einem günstigeren
Arbeitspunkt betrieben werden können, und wodurch, wie
sich zeigte, auch der Frequenzbereich, in dem die Gleichtaktkompensation und PSRR-Dämpfung stattfindet, vergrößert wird.

Fig. 2 zeigt noch einen nachgeschalteten Zusatzverstärker 10 bis 17, der mitintegrierte, eine Selbsterregung
verhindernde Kondensatoren C100, C200 aufweist und
dessen Aufbau im wesentlichen dem bekannten Zusatzverstärker 10 bis 17 gleicht. Der Zusatzverstärker dient insbesondere zur möglichst raschen Umladung von am Ausgang Aus angeschlossenen kapazitiven Lasten. Der Kondensator C27 dient zur Verminderung der durch sonstige Eigenkapazitäten bedingten Phasendrehung der Signale und damit zur Erhöhung der ausnutzbaren Bandbreite des Operationsverstärkers.

Der gesamte Operationsverstärker einschließlich Zusatzverstärker ist sogar dann mit großen Herstellungstoleranzen herstellbar, wenn der zur Kompensation der Gleichtaktkomponente und zur Weitergabe der Differenzkomponente an sich unnötige Drainwiderstand 3 wegge-lassen wird, also wenn dieser Drainwiderstand 3 unendlich kurzen Kanalbereich aufweist. Das Weglassen des Drainwiderstandes 3 verbessert sogar das Einschwingverhalten des Operationsverstärkers, wenn er, an P16 geerdet und an P15/P14 von einem Zusatzkondensator überbrückt, als Integrator verwendet wird.

Bevorzugt ist die Dotierungsintensität der Verstärker-FETs 1, 2, 100, 200 möglichst schwach, nämlich gleich groß wie im z.B. 30 Ωcm-Zustand aufweisenden Substrat, um ein möglichst geringes Rauschen des Verstärkers zu erreichen.

Wenn alle FETs einen n-Kanal aufweisen, ist die ausnutzbare Bandbreite des Operationsverstärkers besonders groß. Die in Figur 3 gezeigte Weiterbildung unterscheidet sich von der in Figur 2 gezeigten Weiterbildung vor allem durch das Weglassen des Zusatzverstärkerzweiges 14, 15 und durch die Einfügung des die Selbsterregung verhindernden Widerstandes M wodurch der Leistungsverbrauch des gesamten Operationsverstärkers weiter sinkt.

Um sicherzustellen, daß die Verstärker-FETs 1, 100 mit enger Herstellungstoleranz doppelt so große Verhältnisse Sv aufweisen wie die Verstärker-FETs 2, 200, wurden beim bekannten Operationsverstärker die Verstärker-FETs 1, 100 durch Parallelschaltung jeweils zweier, unter sich gleich aufgebauter FETs 1A/1B und 100A/100B (dort mit M1A/M1A' und M1B/M1B' bezeichnet, vgl. dort Figur 2) gebildet. Dadurch enthält der Differenzverstärker drei Paare von Verstärker-FETs 1A/1B, 2/200, 100A/100B, wobei jeder Verstärker-FET denselben Sv-Wert aufweist. Die Source-Drain-Strecken der beiden Verstärker-FETs jedes Paares, vgl. 2/200, sind jeweils untereinander parallelgeschaltet, die Gates der FETs 1A/1B sind beide

0025970

mit dem Schaltungspunkt P15 verbunden und die Gates
der FETs 100a/100b sind beide mit dem Schaltungspunkt
P16 verbunden.

Die in Fig. 2 gezeigte Weiterbildung weist also in
einem konkreten Beispiel ebenfalls solche FET-Paare
1A/1B, 100A/100B auf. Dieses konkrete Beispiel weist
nur 1,1 mW Leistungsverbrauch auf und ist insbesondere
gemäß folgender Tabelle aufgebaut und betrieben:
(Tabelle auf Seite 21)

7 Patentansprüche
3 Figuren

| FET | $W_{geom.}$ ($\mu$) | $L_{geom.}$ ($\mu$) | $L_{eff.}$ ($\mu$) |
|---|---|---|---|
| 1A | 81 | 11 | 9 |
| 1B | 81 | 11 | 9 |
| 100A | 81 | 11 | 9 |
| 100B | 81 | 11 | 9 |
| 2 | 81 | 11 | 9 |
| 200 | 81 | 11 | 9 |
| 300 | 9 | 87 | 85 |
| 4(=3) | 9 | 87 | 85 |
| 5 | 11 | 19 | 17 |
| 8 | 9 | 35 | 33 |
| 9 | 11 | 19 | 17 |
| 10 | 23 | 11 | 9 |
| 11 | 9 | 15 | 13 |
| 12 | 9 | 13 | 11 |
| 13 | 9 | 115 | 113 |
| 14 | 7 | 43 | 41 |
| 15 | 7 | 49 | 47 |
| 16 | 11 | 23 | 21 |
| 17 | 11 | 27 | 25 |
| 18 | 9 | 35 | 33 |
| 19 | 9 | 153 | 151 |
| 20 | 11 | 19 | 17 |
| 190 | 9 | 153 | 151 |

$C_{100}$ = 0,3 pF

$C_{200}$ = 0,5 pF

$C_{27}$ = 0,2 pF

Verstärkung $>$ 2000 bei tiefen Frequenzen;

Produkt Verstärkung X Bandbreite $>$ 12 MHz;

Fläche 0,08 $mm^2$;

Am Substrat -5,00 Volt.

Ruhepotentiale (Volt):

| P1 | P2 | P3 | P4 | P17 | P6 | P7 | P8 |
|---|---|---|---|---|---|---|---|
| 5,00 | -5,00 | +2,58 | -3,16 | 2,59 | -0,71 | 2,56 | 2,52 |
| P9 | P10 | P11 | P12 | P13 | P14 | P15 | P16 |
| 2,59 | -3,13 | -3,16 | 0,56 | -0,04 | 0,007 | 0,007 | 0,000 |

<u>Patentansprüche.</u>

1. Operationsverstärker in IG-FET-Technologie mit Dämpfung der Gleichtaktkomponente der Eingangssignale, die dem Differenz-Eingangssignal überlagert ist, mit unsymmetrischem Ausgang zur Weitergabe des empfangenen Differenz-Eingangssignals, mit einem Differenzverstärker und mit einer Gleichtakt-Gegenkopplungsschaltung, jeweils mit bevorzugt gesättigten IG-FETs, wobei der Differenzverstärker

- zwischen den Anschlüssen der Gleichstromversorgung eingefügt ist,

- drei Stromzweige mit je einem eigenen Verarmungstyp-Drainwiderstand und mit je einem Anreicherungstyp-Verstärker-FET enthält, bei denen

-- der erste Verstärker-FET im ersten Stromzweig sowie der dritte Verstärker-FET im dritten Stromzweig gemeinsam an ihren Gates mit dem ersten Signaleingang und

-- der zweite Verstärker-FET im zweiten Stromzweig an seinem Gate mit dem zweiten Signaleingang und an seinem Drain, evtl. über einen Zusatzverstärker, mit dem Operationsverstärkerausgang verbunden ist,

-- der dritte Verstärker-FET an seiner Source-Drain-Strecke von der Source-Drain-Strecke eines vierten Anreicherungstyp-Verstärker-FET, dessen Gate mit dem zweiten Signaleingang verbunden ist, überbrückt ist,

-- die im Ruhezustand von gleich großen Strömen durchflossenen Drainwiderstände zumindest im zweiten und im dritten Stromzweig Kanalbreite/Kanallänge-Verhältnisse W/L = S aufweisen, die untereinander alle gleich groß sind, nämlich den Wert Sd aufweisen, und

-- der erste und der zweite Verstärker-FET Kanalbreite/Kanallänge-Verhältnisse S aufweisen, die untereinander gleich groß sind, nämlich jeweils den Wert Sv aufweisen, und

BAD ORIGINAL

der dritte und der vierte Verstärker-FET Kanalbreite/
Kanallänge-Verhältnisse S aufweisen, die untereinander zwar gleich groß sind, aber im Vergleich zum
ersten und zum zweiten Verstärker-FET jeweils halb
so groß sind, nämlich jeweils den Wert 0,5 Sv aufweisen,
- einen für alle drei Stromzweige gemeinsamen Anreicherungstyp-Sourcewiderstand als Stromquelle, deren
Strom sich auf die drei Stromzweige verteilt, enthält,
und
wobei die Gleichtakt-Gegenkopplungsschaltung
- zwischen Anschlüssen der gleichen Gleichstromversorgung, hinsichtlich der Gleichstromversorgung parallel
zum Differenzverstärker, eingefügt ist,
- eine erste Verstärkerstufe, mit einem ersten gesteuerten Hilfs-FET und in Reihe dazu einem zweiten gesteuerten Anreicherungstyp-Hilfs-FET, enthält, bei
dem
-- der erste Hilfs-FET an seinem Gate mit den Drains des
dritten und des vierten Verstärker-FET verbunden ist
und
-- der zweite Hilfs-FET an seinem Gate mit einer mittels
eines Hilfsspannungsteilers aus der gleichen Gleichstromversorgung erzeugten Vorspannung, sowie an seinem Drain mit dem Gate des Sourcewiderstandes des
Differenzverstärkers verbunden ist,
insbesondere für Kondensator-Schalter-Filter eines digitalen Fernsprech-Vermittlungssystems,
d a d u r c h   g e k e n n z e i c h n e t ,   daß
- der erste Hilfs-FET (6/18) der ersten Verstärkerstufe
ein Verarmungstyp-FET ist (Fig. 2 und 3).

BAD ORIGINAL

2. Operationsverstärker in IG-FET-Technologie mit Dämpfung der Gleichtaktkomponente der Eingangssignale, die dem Differenz-Eingangssignal überlagert ist, mit unsymmetrischem Ausgang zur Weitergabe des empfangenen Differenz-Eingangssignals, mit einem Differenzverstärker und mit einer Gleichtakt-Gegenkopplungsschaltung, jeweils mit bevorzugt gesättigten IG-FETs, wobei der Differenzverstärker

- zwischen den Anschlüsssen der Gleichstromversorgung eingefügt ist,

- drei Stromzweige mit je einem eigenen Verarmungstyp-Drainwiderstand und mit je einem Anreicherungstyp-Verstärker-FET enthält, bei denen

-- der erste Verstärker-FET im ersten Stromzweig sowie der dritte Verstärker-FET im dritten Stromzweig gemeinsam an ihren Gates mit dem ersten Signaleingang und

-- der zweite Verstärker-FET im zweiten Stromzweig an seinem Gate mit dem zweiten Signaleingang und an seinem Drain, evtl. über einen Zusatzverstärker, mit dem Operationsverstärkerausgang verbunden ist,

-- der dritte Verstärker-FET an seiner Source-Drain-Strecke von der Source-Drain-Strecke eines vierten Anreicherungstyp-Verstärker-FET, dessen Gate mit dem zweiten Signaleingang verbunden ist, überbrückt ist,

-- die im Ruhezustand von gleich großen Strömen durchflossenen Drainwiderstände zumindest im zweiten und im dritten Stromzweig Kanalbreite/Kanallänge-Verhältnisse W/L = S aufweisen, die untereinander alle gleich groß sind, nämlich den Wert Sd aufweisen, und

-- der erste und der zweite Verstärker-FET Kanalbreite/Kanallänge-Verhältnisse S aufweisen, die untereinander gleich groß sind, nämlich jeweils den Wert Sv aufweisen, und der dritte und der vierte Verstärker-FET Kanalbreite/
Kanallänge-Verhältnisse S aufweisen, die untereinander zwar gleich groß sind, aber im Vergleich zum
ersten und zum zweiten Verstärker-FET jeweils halb
so groß sind, nämlich jeweils den Wert 0,5 Sv aufweisen,

- einen für alle drei Stromzweige gemeinsamen Anreicherungstyp-Sourcewiderstand als Stromquelle, deren
Strom sich auf die drei Stromzweige verteilt, enthält,
und

wobei die Gleichtakt-Gegenkopplungsschaltung

- zwischen Anschlüssen der gleichen Gleichstromversorgung, hinsichtlich der Gleichstromversorgung parallel
zum Differenzverstärker, eingefügt ist,

- eine erste Verstärkerstufe, mit einem ersten gesteuerten Hilfs-FET und in Reihe dazu einem zweiten gesteuerten Anreicherungstyp-Hilfs-FET, enthält, bei
dem

-- der erste Hilfs-FET an seinem Gate mit den Drains des
dritten und des vierten Verstärker-FET verbunden ist
und

-- der zweite Hilfs-FET an seinem Gate mit einer mittels
eines Hilfsspannungsteilers aus der gleichen Gleichstromversorgung erzeugten Vorspannung, sowie an seinem Drain mit dem Gate des Sourcewiderstandes des
Differenzverstärkers verbunden ist,

insbesondere für Kondensator-Schalter-Filter eines digitalen Fernsprech-Vermittlungssystems,
insbesondere nach Patentanspruch 1,

d a d u r c h   g e k e n n z e i c h n e t ,   daß

- die erste Verstärkerstufe (6,7) gleichzeitig den Hilfsspannungsteiler (18, 20) bildet, indem der Drain des zweiten Hilfs-FET (7/20) dieser Verstärkerstufe mit dem Gate dieses zweiten Hilfs-FET (7/20) verbunden ist (Fig. 2 und 3).

3. Operationsverstärker nach Patentanspruch 1 oder 2, d a d u r c h   g e k e n n z e i c h n e t ,  daß
- der ersten Verstärkerstufe (6,7), hinsichtlich der Gleichstromversorgung (+VDD/-VSS), eine zweite Verstärkerstufe (8,9) mit zwei Hilfs-FETs (8,9) parallel geschaltet ist, bei der
-- der erste Hilfs-FET (8) vom Verarmungstyp ist und an seinem Gate mit dem Drain (P9) des zweiten Verstärker-FET (100) sowie an seiner Source (P10), evtl. über einen nachgeschalteten Zusatzverstärker (10 bis 17), mit dem Operationsverstärkerausgang (P14, Aus) verbunden ist und
-- der zweite Hilfs-FET (9) vom Anreicherungstyp an seinem Gate mit dem Gate (P4) des zweiten Hilfs-FET (7) der ersten Verstärkerstufe (6,7) verbunden ist.

4. Operationsverstärker nach Patentanspruch 3, d a d u r c h   g e k e n n z e i c h n e t ,  daß
- die ersten Hilfs-FETs (6,7) beider Verstärkerstufen jeweils vom Verarmungstyp sind und
- die beiden Verstärkerstufen (18/20, 8/9) in elektrischer Hinsicht symmetrisch aufgebaut sind, indem die Kanalbreite/Kanallänge-Verhältnisse S einander entsprechender FETs (18/8, 19/190, 20/9) jeweils gleich groß (S18 = S8, S19 = S190, S20 = S9) sind.

BAD ORIGINAL

5. Operationsverstärker nach Patentanspruch 3 oder 4, d a d u r c h   g e k e n n z e i c h n e t ,  daß

- zwischen dem ersten und dem zweiten Hilfs-FET (6/7 bzw. 18/20, 8/9) jeder Verstärkerstufe jeweils ein zweipolig betriebener Anreicherungstyp-FET (19, 190) eingefügt ist.

6. Operationsverstärker nach einem der Patentansprüche 1 bis 5, d a d u r c h   g e k e n n z e i c h n e t ,  daß

- das Kanalbreite/Kanallänge-Verhältnis S des im ersten Stromkreis (1) enthaltenden Drainwiderstandes (3) unendlich groß ist, daß also dieser Drainwiderstand (3) weggelassen ist, und

- das Kanalbreite/Kanallänge-Verhältnis Sd der im zweiten und im dritten Stromzweig (100, 2/200) enthaltenen Drainwiderstände (300, 4) endlich groß ist.

7. Operationsverstärker nach einem der Patentansprüche 1 bis 6, d a d u r c h   g e k e n n z e i c h n e t ,  daß

- die Kanalbereiche der Verstärker-FETs (1, 2, 100, 200) die gleiche Dotierung mit gleicher Intensität wie das Substrat selbst haben.

# FIG 1

FIG 2

# FIG 3

**Europäisches Patentamt**

# EUROPÄISCHER RECHERCHENBERICHT

Nummer der Anmeldung

EP 80 10 5551.8

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| D | IEEE INT. SOLID STATE CIRCUITS CONF., Band 22, Februar 1979 New York Y.P. TSIVIDIS et al. "A Process Insensitive NMOS Operational Amplifier" Seiten 188, 189; Fig. 1 --- | 1,3 |
| D | IEEE JOURNAL OF SOLID-STATE CIRCUITS, Band SC-13, Nr. 6, Dezember 1978 New York D. SENDEROWICZ et al. "High-Performance NMOS Operational Amplifier" Seiten 760 bis 766; Fig. 10 -- | 1 |
| | FR - A1 - 2 413 818 (N.V. PHILIPS' GLOEILAMPENFABRIEKEN) * Seite 10, Zeile 21 bis Seite 15, Zeile 14; Fig. 8 * ---- | 1 |

**KLASSIFIKATION DER ANMELDUNG (Int.Cl.3)**

H 03 F    3/45

**RECHERCHIERTE SACHGEBIETE (Int. Cl.3)**

H 03 F    3/45

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

X Der vorliegende Recherchenbericht wurde für alle Patentansprüche erstellt

| Recherchenort | Abschlußdatum der Recherche | Prüfer |
|---|---|---|
| Berlin | 04-12-1980 | BORRELLY |

EPA form 1503.1   06.78